# EUROPEAN PATENT SPECIFICATION

(11) **EP 0 582 207 B1**
(45) Date of publication and mention of the grant of the patent: **22.07.1998**
(21) Application number: 93112107.3
(22) Date of filing: 29.07.1993
(51) Int. Cl.: B32B 5/26

(54) **Heat-resisting cushion material**
Hitzebeständiges Polstermaterial
Matériau de rembourrage résistant à la chaleur

(30) Priority: 29.07.1992 JP 202653/92; 21.05.1993 JP 142603/93
(43) Date of publication of application: 09.02.1994
(73) Proprietor: ICHIKAWA CO.,LTD., Tokyo (JP)
(72) Inventor: Oda, Hiroyuki, Ichikawa-shi, Chiba-ken (JP); Takeuchi, Tetsuo, Ichikawa-shi, Chiba-ken (JP)
(74) Representative: Naumann, Ulrich, Dr.-Ing.

(56) References cited:
- EP-A- 0 092 210
- GB-A- 2 057 966
- US-A- 3 937 860
- US-A- 4 534 886
- US-A- 4 726 987

## Description

### Brief Summary of the Invention

The present invention relates generally to a heat-resisting cushion material, and more particularly to a heat-resisting cushion material suitable for a hot pressing machine used in manufacturing laminated sheets for printed circuit boards, decorative plywood for architecture, and like items.

Laminated boards for printed circuits are conventionally manufactured by layering a copper foil on resin-impregnated fabric or so-called prepreg, and then pressing them between hot platens. The resin initially reduces in viscosity to a liquid state, and then gradually hardens. For uniform temperature and pressure distribution, cushion materials capable of enduring repeated use under high temperatures and high pressures are installed on the platens.

Such cushion materials include (a) woven fabric in which all fibers or a main fiber consists of aromatic polyamide fibers, needle-punched felt formed of the above fiber, or a combination of the woven fabric and the needle-punched felt; (b) woven fabric of heat-resisting material such as glass fiber integrated with the needle-punched felt and containing a heat-resisting resin; (c) several laminations of bonded needle-punched felts containing a heat-resisting resin; and (d) a surface layer consisting of a paper or film made of a heat-resisting material bonded on the surface of laminated felts as in (c) above.

EP-A 0 092 910 relates to a wholly aromatic polyamide (PA) fiber non-woven sheet and a process for producing the same. One example of this document describes a non-woven laminate sheet composed of a core layer represented by web B which is covered by an upper and a lower layer represented by web A. Said webs A and B are partially drawn and undrawn. However, this document does nowhere suggest a laminate sheet having the sequence non-drawn PA/drawn PA/non-drawn PA.

However, these prior art heat-resisting cushion materials have critical deficiencies. For instance, the materials of (a) are not suitable for use in automatic loading systems using vacuum suction equipment because of their vary high permeability. The component fibers in the materials of (b) are loose and soft. Therefore, any slight pressure applied through the cushion material tends to form thick mottles on the product being treated. The fibers in the end portions of the cushion material also tend to tray and shorten its useful life. In the materials or (c) and (d), the resins used for bonding the layers of the needle-punched felt to each other or to the surface layers tend to deteriorate and cause ply separation, wrinkling, breakage and resin shrinkage.

Accordingly, an object of the present invention is to alleviate these deficiencies with a heat-resisting cushion material of improved durability which can be used in a hot press of an automatic loading system, and which prevents irregularities and thick mottles from forming on the product being treated without the need of a resin adhesive in the interlayer bonding which will not deteriorate.

These and other objects of the present invention are achieved with a heat-resisting cushion material characterized by a cover layer (2) of non-drawn meta-aromatic polyamide fibers, or a web containing such fibers, applied on a single surface or each surface of a base layer (1) of all, or substantially all, drawn meta-aromatic polyamide fibers, and the assembled layers heat treated at or above the glass transition temperature of the meta-aromatic polyamide fibers.

The heat-resisting cushion material of the base layer is selected from materials in which either woven fabrics or webs are individually or severally overlapped and integrated by needle-punching, wherein fibers of the cover layer pass among interior fibers of the base layer and tangle with each other in the depth direction thereby preventing the layers from separating even after repeated operations. Of course, other bonding means are contemplated such as resin bonding, and the cover layer may also be mixed with an electrically conductive heat-resisting fiber web.

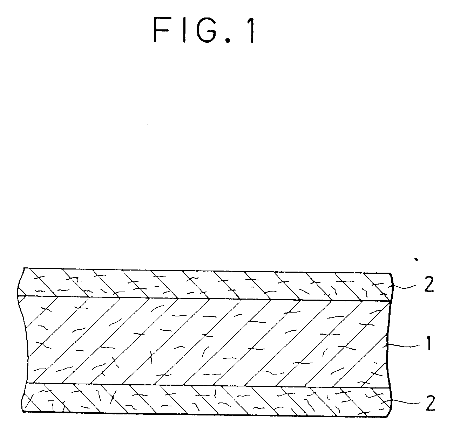

### Brief Description of the Drawing

For a better understanding of these and other objects and aspects of the invention, reference may be made to the following detailed description taken in conjunction with the accompanying drawing wherein:

The sole figure depicts a partially sectional view of a heat-resisting cushion material according to the present invention.

### Description of the Preferred Embodiments

Referring now to the drawing, a heat-resisting cushion material comprises a base layer 1 in which all or substantially all of the constituents are meta-aromatic polyamide fibers bonded to one or each surface of a cover layer 2 of non-drawn meta-aromatic polyamide fibers, or of a web containing such fibers. With any of these constituents, the function of the cushion material is not affected. Further, by mixing cover layer 2 with an electrically conductive heat-resisting fiber web, build-up of static electricity is effectively prevented.

The drawn meta-aromatic polyamide fibers of base layer 1 and the non-drawn meta-aromatic polyamide fibers of cover layer 2 are subjected to hot-pressing at or above the glass transition temperature of the meta-aromatic fibers whereby the surface of cover layer 2 self-bonds, bonds with the other fibers, and fills the spaces between fibers as it softens and deforms. A uniformly thick, smooth and semi-rigid film-like surface of reduced permeability, and greater resistance to abrasion loss and to generation of duet and the like, is thereby produced which is suitable for use in the platens of a hot press in an automatic loading system. Even if the cushion material contains local heavy mottles, a uniform load may be applied to the product being treated without forming thick mottles thereon.

The density of the cushion material is determined to meet specific service conditions, preferably within a range of from 0.45 to 0.75 g/cm³.

The non-drawn aromatic polyamide fibers, or a web containing such fibers, may also be integrated with base layer 1 by needle-punching. In still another bonding method, the component fibers on the press-contact surface may attach to each other at various points during hot pressing. Of course, this usually produces a bonding force which is slightly less than by other methods, but may have sufficient endurance for repeated operations of some systems.

### Example I

Cover layers 2, consisting of a basis weight of 150 g/m² Metsuke webs of 100% non-drawn meta-aromatic polyamide fibers 3-denier x 38 mm in size such as Non-Drawn Conex™ sold by Teijin Ltd., are respectively overlapped on both surfaces of base layer 1 consisting of 1000 g/m² basis weight Metsuke, and then hot pressed at 300°C temperature and 10 kg/cm² pressure for 5 minutes. The resulting heat-resisting cushion material has a density of 0.7 g/cm³.

Table I (below) compares a conventional material with a cushion material according to Example I, and shows that the permeability and abrasion loss are significantly less for the inventive material.

**Table I**

| | Permeability¹ | Abrasion Loss² | Surface Resistance |
|---|---|---|---|
| Inventive material | 15cc | 80 mg | 1 x 10¹⁴Ω or more |
| Conventional material | 48cc | 530 mg | 1 x 10¹⁴Ω or more |

| | | | |
|---|---|---|---|
| ¹Volume of air passing through 1 cm² of material in 1 second at 500 mm Hg vacuum. | | | |
| ²Determined with a Gagushin-type abrasion tester. | | | |

When applied to a suction pad in a hot press of an automatic loading system, the inventive material meets performance requirements, whereas the conventional material does not. The inventive material has only a slight loss or fibers, and no fray of the end portion fibers.

Example I may also have cover layer 2 on only one surface of base layer 1, and base layer 1 may consist of other materials in which only webs, or webs and a woven fabric, are integrated by needling. While not illustrated, a non-drawn aromatic polyamide fiber, or a web containing such a fiber, may be applied in intermediate portions of base layer 1, and the non-drawn aromatic polyamide fibers in cover layer 2 may include the other fibers. The diameter of the fibers and Metsuke specifications may also be varied according to meet specific requirements.

### Example II

Base layer 1 comprises webs formed with 70% drawn meta-aromatic polyamide fibers 5d x 76 mm in size, such as Conex™ sold by Teijin Limited, and 30% drawn aromatic polyamide fibers, as above except 2d x 51 mm in size. Each web is overlapped and integrated with a 100 g/m² plain weave fabric of drawn meta-aromatic polyamide fibers. The webs are then overlapped in three layers and integrated by needle-punching to form a 2000 g/m² basis weight Metsuke.

Cover layer 2, consisting of 150 g/m² basis weight Metsuke webs made of 98% non-drawn meta-aromatic polyamide fibers 3d x 38 mm in size, such as non-drawn Conex™, and 2% anti-static fibers such as Apyeil α™, sold by Unichika, Ltd., are respectively overlapped and needled on both surfaces of base layer 1 forming a lay-up of 2300 g/m² basis weight Metsuke. The lay-up is hot pressed at 300°C and 4 kg/cm² for 10 minutes, to obtain a heat-resistant cushion material of 0.63 g/cm³ density.

Table II (below) compares the material according to Example II and the above-described conventional material, and shows that the permeability and abrasion loss are significantly loss for the inventive material.

**Table II**

| | Permeability¹ | Abrasion Loss² | Surface Resistance |
|---|---|---|---|
| Inventive material | 25 cc/cm²/sec | 110 mg | 1 x 10¹¹Ω or more |
| Conventional material | 48 cc/cm²/sec | 530 mg | 1 x 10¹⁴Ω or more |

| | | | |
|---|---|---|---|
| ¹ and ²: See footnotes at Table I. | | | |

As in Example I, the inventive material of Example II meets performance requirement when applied to a suction pad in apparatus of an automatic loading system, whereas the conventional material does not. There is only a slight loss of fibers and no fray of the end portion fibers. There is also a reduction in surface resistance which suppresses generation of static electricity preventing electric shock and the attraction of dust from the environment.

Example II may also have only one cover layer 2 on a single surface of base layer 1, and use non-drawn meta-aromatic polyamide fibers containing other fibers than single non-drawn meta-aromatic polyamide fibers. In place of the woven fabric, base body 1 may have a web and a woven fabric integrated by needling. The fiber diameters and Metsuke specifications may also be changed as desired.

### Example III

Base layer 1 comprises webs of 70% drawn meta-aromatic fibers 5d x 38 mm in size, 15% of drawn meta-aromatic polyamide fibers 5d x 76 mm in size such as Conex™, and 15% thermoplastic polyphenylene sulfide (PPS) fibers 2d x 51 mm in size overlapped and integrated by needle-punching with a 100 g/m² basis weight plain weave fabric of a drawn meta-aromatic polyamide fiber. The webs are then overlapped in three layers, further integrated by needle-punching, and heat-treated (heat-set in a non-pressing state) in a range between the glass transition temperature and the decomposition temperature of the meta-aromatic polyamide fibers to form a 2000 g/m² basis weight Metsuke.

Cover layers 2 comprise a mixture of 120 g/m² basis weight webs of 80% non-drawn aromatic polyamide fibers, 3d x 38 mm in size, and 20% aromatic polyamide fibers 2d x 60 mm in size such as P-84™ sold by Austria-Renching Company, which are integrated by slight needling. Cover layers 2 are respectively disposed on both surfaces of base layer 1 without needle-punching and hot-pressed at 290°C and 40 kg/cm³ pressure.

Table III compares the material according to Example III and the above-described conventional material, and shows that the permeability and abrasion loss are significantly less for the inventive material.

**Table III**

| | Permeability¹ | Abrasion Loss² | Surface Resistance |
|---|---|---|---|
| Inventive material | 3 cc/cm²/sec | 80 mg | 1 x 10¹⁴Ω or more |
| Conventional material | 48 cc/cm²/sec | 530 mg | 1 x 10¹⁴Ω or more |

| | | | |
|---|---|---|---|
| ¹ and ²: See footnotes at Table I. | | | |

The resulting material of Example III performed better in a suction pad of an automatic loading system than the materials of Example I and II. Also, the addition of thermoplastic fibers in base layer 1 not only reduced fall-out of fibers, but also the generation of dust from the end portion cut surface. Since cover layer 2 includes aromatic polyimide fibers which is less capable of softening-deformation during heat treatment than non-drawn meta-aromatic polyamide fiber, the surface of the cushion material of Example III is very flexible and more resistant to wrinkling.

In each of the above-described examples, the heat-resisting cushion material includes at least one cover layer 2 of non-drawn meta-aromatic polyamide fibers, or a web containing such fibers, on a single surface or each surface of a base layer 1 in which all, or substantially all of the fibers are drawn meta-aromatic polyamide fibers. The combined layers are then heat treated at or above the glass transition temperature of the meta-aromatic polyamide fibers. The cushion material produced in this manner provides reduced permeability and abrasion loss, particularly suitable for use in a hot press apparatus of an automatic loading system.

Moreover, since the fibers in the cover layer 2 are in the form of flat bonding, it is difficult to wrinkle when being folded or creased during handling. By mixing drawn meta-aromatic polyamide fibers, which have less softening-deformation during heat treatment than non-drawn meta-aromatic polyamide fibers or the aromatic polyimide fibers, there is less likelihood of wrinkling. The cover layer surface returns to its original smoothness, whereby irregularities and thick mottles on the product being treated are prevented. Even if heavy mottles were present in the cushion material, they are not reproduced on the product being treated. Hence, product quality and yield is improved. Further, since the cover layer may be bonded to the base layer by means other than resin bonding, ply separation, wrinkling, breakage and resin shrinkage due to the deterioration of the resin adhesive are alleviated. Even when bonded by other means including resin bonding, separation of the cover layer from the base layer is prevented with repeated operations of vacuum suction. As a result, a heat-resisting cushion material is provided which is capable of enhancing its service life workability, and the quality of the articles being treated.

By mixing a conductive heat-resisting fiber web with the above cover layer, electrical resistance of the surface of the heat-resisting cushion material is reduced preventing the static electricity from being generated.

It will be understood that various changes in the details, materials, steps and arranement of parts, which have been herein described and illustrated in order to explain the nature of the invention, may be made by those skilled in the art within the principle and scope of the invention as expressed in the appended claims.

## Claims

1. A heat-resisting cushion comprising, in combination: a base layer (1) of substantially drawn meta-aromatic polyamide fibers, said base layer (1) being selected from a group consisting of (a) woven fabrics individually overlapped and needled, (b) webs individually overlapped and needled, and (c) webs and woven fabrics overlapped and integrated by needling; and on at least one surface of said base layer (1) a cover layer (2) selected from a group consisting of a non-drawn meta-aromatic polyamide fiber and a web containing non-drawn meta-aromatic polyamide fiber; said combined layers (1, 2) being heat treated at or above the glass transition temperatures of said meta-aromatic polyamide fibers.

2. A heat-resisting cushion material according to claim 1 wherein said non-drawn fibers are contained in a web.

3. A heat-resisting cushion material according to claim 1 wherein said base layer (1) and said cover layer (2) are integrated by non-resin bonding means.

4. A heat-resisting cushion material according to claim 1 wherein said cover layer (2) further includes a conductive heat-resisting fiber web.

5. A heat-resisting cushion material according to claim 2 wherein said cover layer (2) further includes a conductive heat-resisting fiber web.

6. A heat-resisting cushion material according to claim 3 wherein said cover layer (2) further includes a conductive heat-resisting fiber web.

## Patentansprüche

1. Ein hitzebeständiges Polstermaterial, in Kombination umfassend: eine Basisschicht (1) aus im wesentlichen gezogenen meta-aromatischen Polyamidfasern, wobei die Basisschicht (1) aus einer Gruppe ausgewählt ist, bestehend aus (a) individuell überlappenden und gesteppten Webwaren, (b) individuell überlappenden und gesteppten Geweben und (c) überlappenden und durch Steppen integrierten Geweben und Webwaren; und eine auf mindestens einer Oberfläche der Basisschicht (1) angeordnete Deckschicht (2), die aus einer Gruppe ausgewählt ist, bestehend aus einer nicht gezogenen meta-aromatischen Polyamidfaser und einem Gewebe, das eine nicht gezogene meta-aromatische Polyamidfaser umfaßt, wobei die kombinierten Schichten (1, 2) bei den Glasumwandlungstemperaturen der meta-aromatischen Polyamidfasern hitzebehandelt sind oder bei höheren Temperaturen.

2. Ein hitzebeständiges Polstermaterial nach Anspruch 1, wobei die nicht gezogenen Fasern in einem Gewebe beinhaltet sind.

3. Ein hitzebeständiges Polstermaterial nach Anspruch 1, wobei die Basisschicht (1) und die Deckschicht (2) über nicht harzartige Bindemittel integriert sind.

4. Ein hitzebeständiges Polstermaterial nach Anspruch 1, wobei die Deckschicht (2) des weiteren ein leitfähiges hitzebeständiges Fasergewebe umfaßt.

5. Ein hitzebeständiges Polstermaterial nach Anspruch 2, wobei die Deckschicht (2) des weiteren ein leitfähiges hitzebeständiges Fasergewebe umfaßt.

6. Ein hitzebeständiges Polstermaterial nach Anspruch 3, wobei die Deckschicht (2) des weiteren ein leitfähiges hitzebeständiges Fasergewebe umfaßt.

## Revendications

1. Matériau de rembourrage résistant à la chaleur, comprenant en combinaison: une couche de base (1) de fibres de polyamide méta-aromatiques en substance étirées, ladite couche de base (1) étant choisie dans un groupe qui comprend (a) des structures tissées se chevauchant individuellement et aiguilletées, (b) des tissus se chevauchant individuellement et aiguilletés, et (c) des tissus et des structures tissées se chevauchant et réunis par aiguilletage; et sur au moins une face de ladite couche de base (1): une couche de recouvrement (2) choisie dans un groupe comprenant des fibres de polyamide méta-aromatiques non étirées et un tissu contenant des fibres de polyamide méta-aromatiques non étirées, lesdites couches combinées (1, 2) étant soumises à un traitement thermique à des températures de transition en verre ou à des températures supérieures desdites fibres de polyamide méta-aromatiques.

2. Matériau de rembourrage résistant à la chaleur suivant la revendication 1, dans lequel lesdites fibres non étirées sont contenues dans un tissu.

3. Matériau de rembourrage résistant à la chaleur suivant la revendication 1, dans lequel ladite couche de base (1) et ladite couche de recouvrement (2) sont réunies par des moyens de liaison exemptes de résine.

4. Matériau de rembourrage résistant à la chaleur suivant la revendication 1, dans lequel ladite couche de recouvrement (2) comprend en outre un tissu conducteur de fibres résistant à la chaleur.

5. Matériau de rembourrage résistant à la chaleur suivant la revendication 2, dans lequel ladite couche de recouvrement (2) comprend en outre un tissu conducteur de fibres résistant à la chaleur.

6. Matériau de rembourrage résistant à la chaleur suivant la revendication 3, dans lequel ladite couche de recouvrement (2) comprend en outre un tissu conducteur de fibres résistant à la chaleur.
